# EUROPEAN PATENT APPLICATION

(11) **EP 4 672 874 A1**
(43) Date of publication of application: **31.12.2025**
(21) Application number: 24770518.9
(22) Date of filing: 27.02.2024
(51) Int. Cl.: H05K 3/40, H01L 21/768, H05K 1/11

(54) **METHOD FOR MANUFACTURING SUBSTRATE WITH CONDUCTIVE VIA, AND METHOD FOR MANUFACTURING WIRING SUBSTRATE WITH CONDUCTIVE VIA**

(30) Priority: 15.03.2023 JP 2023040858
(71) Applicant: Resonac Corporation, Tokyo 105-7325 (JP)
(72) Inventor: SAKAMOTO Masumi, Tokyo 105-7325 (JP); EJIRI Yoshinori, Tokyo 105-7325 (JP); SHIMIZU Chiaki, Tokyo 105-7325 (JP); SUKATA Shinichirou, Tokyo 105-7325 (JP); NAKAKO Hideo, Tokyo 105-7325 (JP)
(74) Representative: Kraus & Lederer PartGmbB
(86) International application number: PCT/JP2024/007150
(87) International publication number: WO 2024/190406

(57) **Abstract**

A method for manufacturing a substrate with conductive vias includes a step a of preparing a substrate provided with holes, and providing a metal paste portion containing metal particles and a volatile solvent so as to fill the inside of the holes and cover at least a surface of the substrate around the holes; a step b of heating the metal paste portion to remove a part of the volatile solvent; a step c of removing a part of the metal paste portion after heating so as to expose the surface, and forming conductive via precursors having a flattened exposed surface and containing a remainder of the metal particles and the volatile solvent inside the holes; and a step d of firing the conductive via precursors to form conductive vias.

## Description

### Technical Field

The present invention relates to a method for manufacturing a substrate with conductive vias and a method for manufacturing a wiring board with conductive vias.

### Background Art

In recent years, for the purpose of size reduction, functional enhancement, and integration of electronic equipment or components, attention has been paid to a three-dimensional mounting technique of electrically connecting silicon substrates that are disposed up and down via electrodes called through-silicon vias (TSVs) to a silicon substrate and laminating semiconductor chips in a vertical direction (height direction) at a high density.

As a technique for forming through-silicon vias, for example, Patent Literature 1 discloses a method for manufacturing a semiconductor device having through-silicon vias, the method including a step of plating non-through vias formed in a silicon substrate with copper by electroplating using a specific copper plating solution.

### Citation List

### Patent Literature

Patent Literature 1: Japanese Unexamined Patent Publication No. 2019-16712

### Summary of Invention

### Technical Problem

However, in the method described above, since it is necessary to perform plating while suppressing a precipitation rate of a copper coating, a work time is extended, and there is a problem in terms of productivity. In addition, planarization is performed by chmeical mechanical polishing (CMP) for multi-layering, but when there is a CMP step, there are disadvantages such as a decrease in productivity due to the time required for polishing, a risk of cracking of a substrate due to polishing, and the like.

Therefore, an object of the present invention is to provide a method for manufacturing a substrate with conductive vias capable of easily obtaining a substrate with conductive vias having sufficient flatness. In addition, another object of the present invention is to provide a method for manufacturing a wiring board with conductive vias capable of easily obtaining a wiring board with conductive vias having a wiring connected by the conductive vias.

### Solution to Problem

In order to solve the problems described above, an aspect of the present invention provides the following method for manufacturing a substrate with conductive vias and method for manufacturing a wiring board with conductive vias.
[1] A method for manufacturing a substrate with conductive vias, the method including: a step a of preparing a substrate provided with holes, and providing a metal paste portion containing metal particles and a volatile solvent so as to fill the inside of the holes and cover at least a surface of the substrate around the holes; a step b of heating the metal paste portion to remove a part of the volatile solvent; a step c of removing a part of the metal paste portion after heating so as to expose the surface, and forming conductive via precursors having a flattened exposed surface and containing a remainder of the metal particles and the volatile solvent inside the holes; and a step d of firing the conductive via precursors.
[2] The method according to [1], in which a concentration of the metal particles in the metal paste portion provided in the step a is 94 mass% or more, and in the step b, the metal paste portion is heated so that the concentration of the metal particles is 97.5 mass% or more.
[3] The method according to [1] or [2], in which the volatile solvent contains a high vapor pressure solvent having a vapor pressure at 20°C of 4 Pa or more and 30 Pa or less, and a heating temperature in the step b is lower than 100°C.
[4] The method according to any one of [1] to [3], in which in the step a, a metal particle film including a support film and a metal particle-containing layer provided on the support film and containing the metal particles and the volatile solvent is prepared, and the metal paste portion is provided by pressing the metal particle-containing layer of the metal particle film against the substrate.
[5] A method for manufacturing a wiring board with conductive vias, the method including a step of forming a wiring on a substrate with conductive vias obtained by the method according to any one of [1] to [4].

### Advantageous Effects of Invention

According to the present invention, a substrate with conductive vias having sufficient flatness can be easily obtained. That is, according to the method described in [1], in the step a, the metal paste portion containing the metal particles and the volatile solvent is provided, and then the step b and the step c are performed, such that the substrate surface and the exposed surface of the conductive via precursor can be aligned while achieving both excellent filling of the inside of the holes and formation of the conductive via precursors that are less likely to undergo volume shrinkage by firing, and the conductive vias can be formed while sufficiently reducing the step with respect to the substrate surface by the step d. Therefore, a substrate with conductive vias having sufficient flatness can be easily obtained, and a planarization step such as a CMP step can be omitted.

In addition, according to the present invention, a wiring board with conductive vias having a wiring connected by the conductive vias can be easily obtained.

### Brief Description of Drawings

FIG. 1 is a schematic view showing an example of a method for manufacturing a substrate with conductive vias according to the present embodiment.
FIG. 2 is a schematic view showing an example of a method for manufacturing a substrate with conductive vias according to the present embodiment.
FIG. 3 is a schematic view showing an example of a method for manufacturing a substrate with conductive vias according to the present embodiment.
FIG. 4 is a schematic view showing an example of a method for manufacturing a wiring board with conductive vias according to the present embodiment.
FIG. 5 is a schematic view showing a test piece.
FIG. 6 is a cross-sectional photograph of a conductive via in a silicon substrate with conductive vias prepared in Example 1.
FIG. 7 is a cross-sectional photograph of a conductive via in a sample prepared in Example 1.

### Description of Embodiments

Hereinafter, embodiments of the present invention will be described in detail with reference to the drawings. The present invention is not limited to the following embodiments. Note that, in the drawings, the same or corresponding parts are denoted by the same reference signs, and redundant description will be omitted.

### <Method for Manufacturing Substrate with Conductive Vias>

A method for manufacturing a substrate with conductive vias according to the present embodiment includes: a step a of preparing a substrate provided with holes, and providing a metal paste portion containing metal particles and a volatile solvent so as to fill the inside of the holes and cover at least a surface of the substrate around the holes; a step b of heating the metal paste portion to remove a part of the volatile solvent; a step c of removing a part of the metal paste portion after heating so as to expose the surface, and forming conductive via precursors having a flattened exposed surface and containing a remainder of the metal particles and the volatile solvent inside the holes; and a step d of firing the conductive via precursors to form conductive vias.

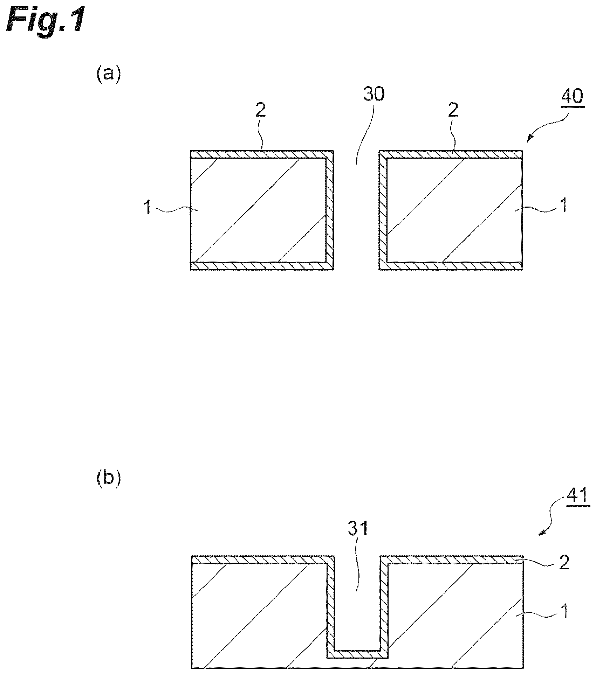

FIGS. 1 to 3 are schematic views showing examples of a method for manufacturing a substrate with conductive vias according to the present embodiment. FIG. 1 illustrates an example of a substrate used in the method for manufacturing a substrate with conductive vias. Hereinafter, the method for manufacturing a substrate with conductive vias according to the present embodiment will be described with reference to these drawings.

### [Step a]

Examples of the substrate provided with holes prepared in the step include a silicon substrate, a glass substrate, a ceramic substrate, a printed wiring board, and a semiconductor package substrate. The hole may be a through-hole or a non-through-hole. In the present embodiment, for example, as illustrated in FIG. 1(a), a silicon substrate 40 including a silicon wafer 1 provided with a through-hole 30 and a metal coating 2 provided on a wall surface of the through-hole and a surface of the silicon wafer 1 can be prepared. The through-hole 30 communicates with both main surfaces of the silicon substrate 40. Although a case where conductive vias are provided in the silicon substrate 40 will be described as an example, a silicon wafer may be replaced with another insulating substrate in the following description.

A thickness of the silicon wafer 1 may be 100 µm or more, 200 µm or more, or 300 µm or more, from the viewpoint of suppressing warpage of the substrate after sintering, and may be 800 µm or less, 300 µm or less, 200 µm or less, or 100 µm or less from the viewpoint of weight reduction and high density of the substrate.

An upper limit value of a hole diameter of the through-hole 30 may be 200 µm or less, 100 µm or less, or 60 µm or less from the viewpoint of increasing the density of the obtained semiconductor device, and a lower limit value of the hole diameter of the through-hole 30 is not particularly limited, and may be 20 µm or more, 30 µm or more, or 50 µm or more.

The number of through-holes 30 provided in the silicon substrate 40 may be 100 or more, 200 or more, or 300 or more per 1 cm² of the main surface of the substrate from the viewpoint of increasing the density of the obtained semiconductor device.

The metal coating 2 may be provided on both main surfaces of the silicon wafer 1 and the wall surface of the through-hole 30, may be provided on at least one main surface of the silicon wafer 1 and the wall surface of the through-hole 30, may be provided only on the wall surface of the through-hole 30, or may not be provided. In the embodiment illustrated in FIG. 1(a), the silicon substrate 40 includes a metal coating 2 formed on both main surfaces of the silicon wafer 1 and on the wall surface of the through-hole 30.

Examples of the metal coating 2 include titanium, nickel, chromium, copper, aluminum, palladium, platinum, and gold. From the viewpoint of adhesion, the metal coating 2 is preferably a coating in which titanium, nickel, and copper layers are formed in this order. By oxidizing the surface of the silicon wafer 1 to form silicon oxide and forming a titanium layer on the silicon oxide, adhesiveness is improved. In addition, a nickel layer is provided on the titanium layer and a copper layer is provided thereon, such that it is possible to suppress diffusion of copper into the silicon wafer 1 as compared with a case where the copper layer is directly provided on the titanium layer. Further, the copper layer is formed on the surface, such that the adhesion between the copper layer and the copper particles in the metal paste is improved, and the reliability is improved.

Note that, as illustrated in FIG. 1(b), in a case of preparing a silicon substrate 41 in which a non-through-hole 31 is provided as a hole, a conductive via serving as a through-electrode can be formed by grinding a side of the silicon substrate opposite to a surface in which the non-through-hole 31 is opened, after the step a, the step b, the step c, or the step d. Examples of the grinding method include mechanical polishing and chemical mechanical polishing.

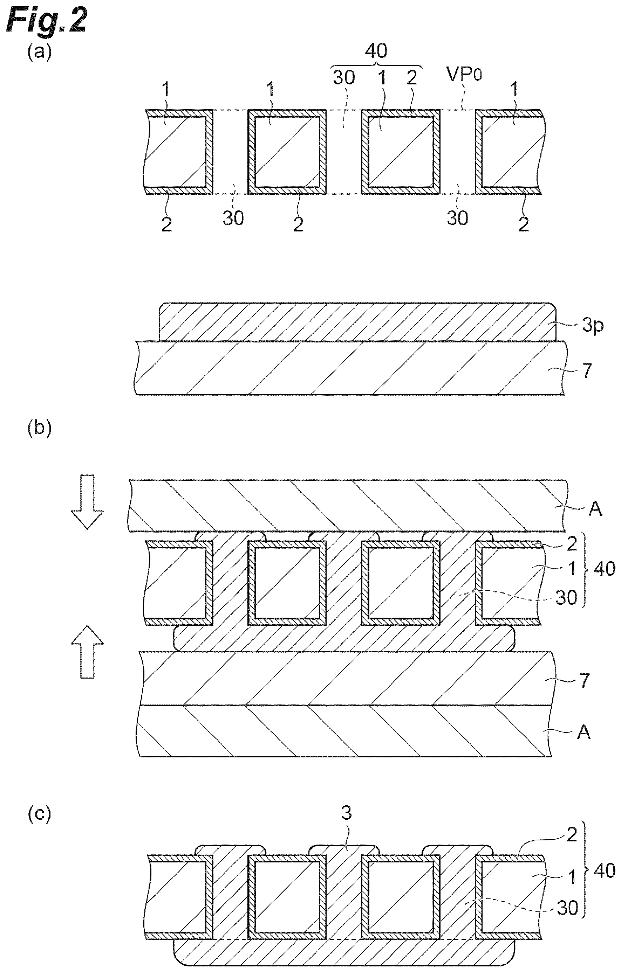

As illustrated in FIGS. 2(a) to 2(c), a metal paste portion 3 can be provided, for example, by preparing a metal particle film in which a metal particle-containing layer 3p formed of a metal paste is provided on a support film 7, and pressing the metal particle film against the substrate.

Examples of the support film 7 include a polyimide film, a polyethylene naphthalate film, and a polyethylene terephthalate film. A thickness of the support film may be 20 to 200 µm, 25 to 175 µm, or 30 to 150 µm from the viewpoint of workability for forming the metal particle-containing layer by coating.

### (Metal Paste)

The metal paste contains metal particles and a volatile solvent.

A concentration of the metal particles in the metal paste may be 92 mass% or more, 94 mass% or more, or 95 mass% or more, and may be 98 mass% or less, 97 mass% or less, or 96 mass% or less.

Examples of the metal particles include particles of nickel, silver, copper, gold, palladium, platinum, solder, and the like. When the metal paste contains copper particles and solder particles, it is easy to obtain a conductor having sufficient conductivity and a resistance value that does not easily increase even when subjected to a temperature change, and a substrate including a through-electrode having sufficient conductivity and excellent connection reliability. In the present embodiment, the metal particles may include first copper particles having an average particle diameter of 0.8 µm or more, second copper particles having an average particle diameter of 0.4 µm or less, and solder particles.

Note that, in the present specification, the average particle diameter of the particles means a 50% volume average particle diameter (D50). When the volume average particle diameter of the metal particles is determined, the volume average particle diameter can be determined by a method in which metal particles as a raw material are dispersed in a dispersion medium such as water or alcohol, and a volume average particle diameter is measured with a laser diffraction/scattering particle diameter distribution measuring apparatus or the like.

An average particle diameter of the first copper particles may be 0.8 µm or more, 1.0 µm or more, 2.0 µm or more, or 3.0 µm or more from the viewpoint of improving the sintering density in the holes (for example, the through-holes or the non-through-holes) of the substrate and suppressing the occurrence of voids and cracks in the holes. For example, the average particle diameter of the first copper particles may be 10 µm or less, 8.0 µm or less, 5.0 µm or less, or 4.0 µm or less from the viewpoint of suppressing clogging of the particles in the fine via having an inner diameter of 50 µm or less and improving the filling property, and may be 0.8 µm to 4.0 µm, 1.0 µm to 3.5 µm, or 1.2 µm to 3.0 µm from the viewpoint of suppressing the occurrence of voids and cracks and suppressing clogging of the particles in the fine via.

The shapes of the first copper particles may be, for example, a spherical shape, a lump shape, a needle shape, a flat shape (flake shape), a substantially spherical shape, and the like. The first copper particles may be an aggregate of copper particles having these shapes. The metal paste of the present embodiment can contain spherical copper particles as the first copper particles from the viewpoint of reducing the step between the conductive via portion to be formed and the substrate surface and suppressing the fluctuation in connection resistance even after a reliability test (for example, a temperature cycle test).

In the first copper particles, a content ratio of particles having an aspect ratio of 2 or less, such as spherical particles, may be 60 mass% or more, 80 mass% or more, or 100 mass%, from the viewpoint of improving the printability of the metal paste. Note that the aspect ratio (major axis/minor axis) of the particle can be determined, for example, by observing an SEM image of the particle and measuring the major axis and the minor axis (for example, thickness).

The first copper particles may be prepared by a chemical reduction method, an atomization method, an electrolytic method, a pulverization method, a plasma rotary electrode method, a homogeneous liquid spraying method, a heat treatment method, or the like, and may be a wet copper powder or an atomized copper powder from the viewpoint of easily obtaining a uniform diameter and improving the dispersibility of the metal paste.

The first copper particles may contain a wet copper powder. In this case, a conductive via having excellent conductivity is easily obtained. Such an effect is considered to be obtained by the property that the wet copper powder is easily bonded to the second copper particles. The wet copper powder may have D90/D50 of 1.5 or less.

In addition, the first copper particles can contain a wet copper powder and an atomized copper powder. In this case, it is easy to improve the printability of the metal paste, to reduce the step between the conductive via portion to be formed and the substrate surface, and to suppress the fluctuation of the connection resistance even after the reliability test (for example, the temperature cycle test). The reason why such an effect can be obtained is presumed as follows. That is, it is considered that, since the wet copper powder that is easily bonded to the second copper particles and has a uniform particle diameter and the atomized copper powder having a wide particle diameter distribution coexist, the wet copper powder is bonded to the second copper particles while bonding between the atomized copper powders, such that the formation of a rigid sintered body due to the closest packed structure, the suppression of the occurrence of voids or cracks due to suppression of shrinkage during sintering, and the suppression of recesses can be achieved. The atomized copper powder may have D90/D50 of 1.6 or more, 1.7 or more, or 1.8 or more.

When the first copper particles contain the wet copper powder and the atomized copper powder, a content ratio of the wet copper powder may be more than 0 parts by mass and less than 100 parts by mass, or may be 20 to 80 parts by mass, with respect to 100 parts by mass of the total amount of the wet copper powder and the atomized copper powder.

As the first copper particles, commercially available copper particles can be used. Examples of the commercially available first copper particles include 1050Y (trade name, manufactured by MITSUI MINING & SMELTING CO., LTD., average particle diameter (D50): 0.81 µm, D90: 1.1 µm, spherical shape, wet copper powder), 1100Y (trade name, manufactured by MITSUI MINING & SMELTING CO., LTD., average particle diameter (D50): 1.1 µm, D90: 1.6 µm, spherical shape, wet copper powder), 1200Y (trade name, manufactured by MITSUI MINING & SMELTING CO., LTD., average particle diameter (D50): 2.1 µm, D90: 3.1 µm, spherical shape, wet copper powder), 1300Y (trade name, manufactured by MITSUI MINING & SMELTING CO., LTD., average particle diameter (D50): 3.5 µm, D90: 5 µm, spherical shape, wet copper powder), 1100YP (trade name, manufactured by MITSUI MINING & SMELTING CO., LTD., average particle diameter (D50): 1.4 µm, D90: 2.3 µm, flat shape, wet copper powder), 1200YP (trade name, manufactured by MITSUI MINING & SMELTING CO., LTD., average particle diameter (D50): 3.1 µm, D90: 5.3 µm, flat shape, wet copper powder), MA-C02K (trade name, manufactured by MITSUI MINING & SMELTING CO., LTD., average particle diameter (D50): 1.8 µm, D90: 3.6 µm, spherical shape, atomized copper powder), MA-C025K (trade name, manufactured by MITSUI MINING & SMELTING CO., LTD., average particle diameter (D50): 2.4 µm, D90: 5.2 µm, spherical shape, atomized copper powder), and MA-C03K (trade name, manufactured by MITSUI MINING & SMELTING CO., LTD., average particle diameter (D50): 3.4 µm, D90: 6.3 µm, spherical shape, atomized copper powder).

The first copper particles may be treated with a surface treatment agent from the viewpoint of dispersion stability and oxidation resistance. The surface treatment agent may be removed during wiring formation (during sintering of copper particles). Examples of such a surface treatment agent include aliphatic carboxylic acids such as palmitic acid, stearic acid, arachidic acid, and oleic acid; aromatic carboxylic acids such as terephthalic acid, pyromellitic acid, and o-phenoxybenzoic acid; aliphatic alcohols such as cetyl alcohol, stearyl alcohol, isobornyl cyclohexanol, and tetraethylene glycol; aromatic alcohols such as p-phenylphenol; alkylamines such as octylamine, dodecylamine, and stearylamine; aliphatic nitriles such as stearonitrile and decane nitrile; silane coupling agents such as alkylalkoxysilane; and polymer treatment agents such as polyethylene glycol, polyvinyl alcohol, polyvinyl pyrrolidone, and silicone oligomers. The surface treatment agents may be used alone, or may be used in combination of two or more kinds.

A treatment amount of the surface treatment agent may be an amount of one or more molecular layers on the particle surface. The treatment amount of such a surface treatment agent varies depending on the specific surface area of the first copper particle, the molecular weight of the surface treatment agent, and the minimum coating area of the surface treatment agent. The treatment amount of the surface treatment agent is usually 0.001 mass% or more.

The treatment amount of the surface treatment agent can be calculated from the number (n) of molecular layers attached to the surface of the first copper particle, the specific surface area (Aₚ) (unit: m²/g) of the first copper particles, the molecular weight (Mₛ) (unit: g/mol) of the surface treatment agent, the minimum coating area (S_{S}) (unit: m²/unit) of the surface treatment agent, and the Avogadro's number (N_{A}) (6.02 × 10²³). Specifically, the treatment amount of the surface treatment agent is calculated according to the expression of the treatment amount (mass%) of the surface treatment agent = {(n × Aₚ × Mₛ)/(S_{S} × N_{A} + n × Aₚ × Mₛ)} × 100%.

The specific surface area of the first copper particle can be calculated by measuring the dried copper particle by the BET specific surface area measurement method. The minimum coating area of the surface treatment agent is 2.05 × 10⁻¹⁹ m²/1 molecule when the surface treatment agent is a linear saturated fatty acid. In the case of other surface treatment agents, for example, it can be measured through calculation from a molecular model or by the method described in "Chemistry and Education" (UEDA KATSUHIRO, INAFUKU SUMIO, and MORI IWAO, 40(2), 1992, p. 114-117). An example of a quantitative method of the surface treatment agent will be described. The surface treatment agent can be identified by a thermal desorption gas and gas chromatography mass analyzer of a dry powder obtained by removing the dispersion medium from the metal paste, and according to this, it is possible to determine the number of carbons and the molecular weight of the surface treatment agent. A carbon content ratio of the surface treatment agent can be analyzed through carbon content analysis. Examples of the carbon content analysis method include a highfrequency induction heating furnace combustion and infrared absorption method. The amount of the surface treatment agent can be calculated from the number of carbons, the molecular weight, and the carbon content ratio of the surface treatment agent that is identified by the expression described above.

### (Second Copper Particles)

An average particle diameter of the second copper particles may be 0.4 µm or less, 0.3 µm or less, or 0.2 µm or less from the viewpoint of sinterability, may be 0.01 µm or more, 0.03 µm or more, 0.05 µm or more, 0.08 µm or more, or 0.1 µm or more from the viewpoint of suppression of synthesis cost, excellent dispersibility, suppression of the amount of the surface treatment agent used, and may be 0.1 µm to 0.3 µm, 0.12 µm to 0.28 µm, or 0.15 µm to 0.25 µm from the viewpoint of obtaining sinterability at a low temperature and excellent dispersibility in the paste.

The second copper particles can act as copper particles that suitably bond the first copper particles. In addition, the second copper particles are more excellent in sinterability than the first copper particles, and can have a function of promoting sintering of the copper particles. For example, the copper particles can be sintered at a lower temperature as compared with the case where the first copper particles are used alone as the copper particles.

The second copper particles may be a wet copper powder prepared by a chemical reduction method.

The shapes of the second copper particles may be, for example, a spherical shape, a lump shape, a needle shape, a flat shape (flake shape), a substantially spherical shape, and the like. The second copper particles may be an aggregate of copper particles having these shapes. From the viewpoint of the dispersibility and the filling property, the shapes of the second copper particles may be a spherical shape, a substantially spherical shape, and a flat shape (flake shape), and from the viewpoint of the flammability, the mixing property with the first copper particles, and the like, the shapes of the second copper particles may be a spherical shape or a substantially spherical shape.

An aspect ratio of the second copper particles may be 5 or less, 4 or less, or 3 or less from the viewpoint of the dispersibility, the filling property, and the mixing property with the first copper particles.

As the second copper particles, either synthetic copper particles or commercially available copper particles can be used. Examples of the commercially available second copper particles include CH0200L1 (trade name, manufactured by MITSUI MINING & SMELTING CO., LTD., average particle diameter (D50): 200 nm, spherical shape) and Tn-Cu100 (manufactured by TAIYO NIPPON SANSO CORPORATION, average particle diameter (D50): 120 nm, spherical shape).

The second copper particles may be treated with a specific surface treating agent. Examples of the specific surface treatment agent include an organic acid having 8 to 16 carbon atoms. Examples of the organic acid having 8 to 16 carbon atoms include saturated fatty acids such as caprylic acid, methylheptanoic acid, ethylhexanoic acid, propylpentanoic acid, pelargonic acid, methyloctanoic acid, ethylheptanoic acid, propylhexanoic acid, capric acid, methylnonanoic acid, ethyloctanoic acid, propylheptanoic acid, butylhexanoic acid, undecanoic acid, methyldecanoic acid, ethylnonanoic acid, propyloctanoic acid, butylheptanoic acid, lauric acid, methylundecanoic acid, ethyldecanoic acid, propylnonanoic acid, butyloctanoic acid, pentylheptanoic acid, tridecanoic acid, methyldodecanoic acid, ethylundecanoic acid, propyldecanoic acid, butylnonanoic acid, pentyloctanoic acid, myristic acid, methyl tridecanoic acid, ethyl dodecanoic acid, propyl undecanoic acid, butyl decanoic acid, pentyl nonanoic acid, hexyl octanoic acid, pentadecanoic acid, methyl tetradecanoic acid, ethyl tridecanoic acid, propyl dodecanoic acid, butyl undecanoic acid, pentyldecanoic acid, hexylnonanoic acid, palmitic acid, methylpentadecanoic acid, ethyltetradecanoic acid, propyltridecanoic acid, butyldodecanoic acid, pentylundecanoic acid, hexyldecanoic acid, heptylnonanoic acid, methylcyclohexanecarboxylic acid, ethyl cyclohexane carboxylic acid, propyl cyclohexane carboxylic acid, butyl cyclohexane carboxylic acid, pentyl cyclohexane carboxylic acid, hexyl cyclohexane carboxylic acid, heptyl cyclohexane carboxylic acid, octyl cyclohexane carboxylic acid, and nonyl cyclohexane carboxylic acid; unsaturated fatty acids such as octenoic acid, nonenoic acid, methylnonenoic acid, decenoic acid, undecenoic acid, dodecenoic acid, tridecenoic acid, tetradecenoic acid, myristoleic acid, pentadecenoic acid, hexadecenoic acid, palmitoleic acid, and sabic acid; and aromatic carboxylic acid such as terephthalic acid, pyromellitic acid, o-phenoxybenzoic acid, methylbenzoic acid, ethylbenzoic acid, propylbenzoic acid, butylbenzoic acid, pentylbenzoic acid, hexylbenzoic acid, heptylbenzoic acid, octylbenzoic acid, and nonylbenzoic acid. The organic acids may be used alone, or may be used in combination of two or more kinds. By combining such an organic acid with the second copper particles described above, the dispersibility of the second copper particles and the releasability of the organic acid during sintering tend to be compatible.

A treatment amount of the surface treatment agent may be an amount in which one molecular layer to three molecular layers are attached to the surface of the second copper particle. The treatment amount of the surface treatment agent may be 0.07 mass% or more, 0.10 mass% or more, or 0.2 mass% or more, and may be 2.1 mass% or less, 1.6 mass% or less, or 1.1 mass% or less. The surface treatment amount of the second copper particles can be calculated by the method described above for the first copper particles. The same applies to the specific surface area, the molecular weight of the surface treatment agent, and the minimum coating area of the surface treatment agent.

The total content of the first copper particles and the second copper particles in the metal paste may be 85 to 99.5 parts by mass, 90 to 99 parts by mass, or 95 to 98 parts by mass, when the total mass of the metal particles is 100 parts by mass.

The contents of the first copper particles and the second copper particles may be 5 to 95 parts by mass and 95 to 5 parts by mass, 20 to 80 parts by mass and 80 to 20 parts by mass, or 30 to 70 parts by mass and 70 to 30 parts by mass, respectively, with respect to 100 parts by mass of the total of the first copper particles and the second copper particles.

### (Solder Particles)

Solder particles containing tin or a tin alloy can be used. As the tin alloy, for example, In-Sn, In-Sn-Ag, Sn-Bi, Sn-Bi-Ag, Sn-Ag-Cu, or Sn-Cu-based alloys can be used, and the following examples can be mentioned.
· In-Sn (52 mass% of In, 48 mass% of Sn, melting point: 118°C)
· In-Sn-Ag (20 mass% of In, 77.2 mass% of Sn, 2.8 mass% of Ag, melting point: 175°C)
· Sn-Bi (43 mass% of Sn, 57 mass% of Bi, melting point: 138°C)
· Sn-Bi-Ag (42 mass% of Sn, 57 mass% of Bi, 1 mass% of Ag, melting point: 139°C)
· Sn-Ag-Cu (96.5 mass% of Sn, 3 mass% of Ag, 0.5 mass% of Cu, melting point: 217°C)
· Sn-Cu (99.3 mass% of Sn, 0.7 mass% of Cu, melting point: 227°C)

An average particle diameter of the solder particles may be 1.0 µm or more, 1.5 µm or more, 2.0 µm or more, 3.0 µm or more, or 4.0 µm or more from the viewpoint of suppressing volume shrinkage due to sintering in the holes to suppress the occurrence of voids in the through-holes, may be 15 µm or less, 10 µm or less, 8.0 µm or less, or 5.0 µm or less from the viewpoint of making the distribution of the solder particles in the holes more uniform and reducing the size of the voids generated in the vicinity of the solder particles, and may be 2.0 µm to 8.0 µm, 2.5 µm to 7.0 µm, or 3.0 µm to 6.0 µm from the viewpoint of suppressing volume shrinkage and improving the dispersion of the solder particles to minimize the size of the voids for dispersion. Since the solder particles have such a particle diameter, volume shrinkage when a conductive via precursor to be described below is sintered can be sufficiently reduced, and it is easy to form a conductive via portion in which a conductive network is sufficiently formed in a hole while reducing a step with respect to a substrate surface while having a porous structure. Therefore, a sufficiently low connection resistance value can be exhibited even after the wiring is formed, and disconnection due to thermal stress of the wiring can be further suppressed.

The shapes of the solder particles may be, for example, a spherical shape, a lump shape, a needle shape, a flat shape (flake shape), a substantially spherical shape, and the like. The solder particles may be an aggregate of solder particles having these shapes.

The solder particles preferably have a spherical shape. In this case, the solder particles are uniformly dispersed in the metal body and voids are generated inside the solder uniformly dispersed or in the outer peripheral portion of the solder (between the solder and the copper sintered body), such that volume shrinkage when the conductive via precursor described below is sintered is suppressed, and disconnection generated in the conductive via portion can be easily suppressed.

A content of the solder particles in the metal paste may be 0.3 to 15 parts by mass, 1 to 10 parts by mass, or 2 to 5 parts by mass, when the total mass of the metal particles is 100 parts by mass.

In addition, the content of the solder particles may be 0.2 to 13 parts by mass, 0.8 to 9 parts by mass, or 1.5 to 4 parts by mass, with respect to 100 parts by mass of the total of the first copper particles and the second copper particles contained in the metal paste. When the content of the solder particles is within the range described above, the occurrence of voids or cracks in the holes is suppressed, and it is easy to form a conductive via in which a conductive network is sufficiently formed while having a porous structure.

The metal paste may contain metal particles other than copper particles and solder particles (hereinafter, also referred to as "other metal particles"). Examples of the other metal particles include nickel particles, silver particles, gold particles, palladium particles, and platinum particles. One kind or two or more kinds of these particles can be contained. An average particle diameter of the other metal particles may be 0.01 µm or more, 0.03 µm or more, or 0.05 µm or more, and may be 5 µm or less, 3.0 µm or less, or 2.0 µm or less. A content of the other metal particles may be 5 parts by mass or less, 3 parts by mass or less, or 1 part by mass or less, when the total mass of the metal particles is 100 parts by mass. The other metal particles may not be contained. The shapes of the other metal particles are not particularly limited.

Examples of the volatile solvent include monohydric and polyhydric alcohols such as pentanol, hexanol, heptanol, octanol, decanol, ethylene glycol, diethylene glycol, propylene glycol, butylene glycol (1,3-butanediol or the like), α-terpineol, and isobornyl cyclohexanol (MTPH); ethers such as ethylene glycol butyl ether, ethylene glycol phenyl ether, diethylene glycol methyl ether, diethylene glycol ethyl ether (ethyl carbitol), diethylene glycol butyl ether (diethylene glycol mono-n-butyl ether or the like), diethylene glycol isobutyl ether, diethylene glycol hexyl ether, triethylene glycol methyl ether, diethylene glycol dimethyl ether, diethylene glycol diethyl ether, diethylene glycol dibutyl ether, diethylene glycol butyl methyl ether, diethylene glycol isopropyl methyl ether, triethylene glycol dimethyl ether, triethylene glycol butyl methyl ether, propylene glycol propyl ether, dipropylene glycol methyl ether, dipropylene glycol ethyl ether, dipropylene glycol propyl ether, dipropylene glycol butyl ether, dipropylene glycol dimethyl ether, tripropylene glycol methyl ether, and tripropylene glycol dimethyl ether; esters such as dimethyl phthalate, ethylene glycol ethyl ether acetate, ethylene glycol butyl ether acetate, propylene glycol diacetate, diethylene glycol ethyl ether acetate, diethylene glycol butyl ether acetate, dipropylene glycol methyl ether acetate (DPMA), ethyl lactate, butyl lactate, γ-butyrolactone, and propylene carbonate; acid amides such as N-methyl-2-pyrrolidone, N,N-dimethylacetamide, and N,N-dimethylformamide; aliphatic hydrocarbons such as cyclohexane, octane, nonane, decane, and undecane; aromatic hydrocarbons such as benzene, toluene, and xylene; mercaptans having an alkyl group having 1 to 18 carbon atoms; and mercaptans having a cycloalkyl group having 5 to 7 carbon atoms. Examples of the mercaptans having an alkyl group having 1 to 18 carbon atoms include ethyl mercaptan, n-propyl mercaptan, i-propyl mercaptan, n-butyl mercaptan, i-butyl mercaptan, t-butyl mercaptan, pentyl mercaptan, hexyl mercaptan, and dodecyl mercaptan. Examples of the mercaptans having a cycloalkyl group having 5 to 7 carbon atoms include cyclopentyl mercaptan, cyclohexyl mercaptan, and cycloheptyl mercaptan. The volatile solvents may be used alone, or may be used in combination of two or more kinds.

The metal paste may contain a solvent having a vapor pressure at 20°C of 4 Pa or more and 30 Pa or less (hereinafter, also referred to as a "high vapor pressure solvent") as a volatile solvent from the viewpoint of printability, and suppression of voids or cracks by suppressing volume shrinkage before and after firing the conductive via precursors (for example, between the step of forming the conductive via precursors and the step of firing the conductive via precursors). The high vapor pressure solvents may be used alone, or may be used in combination of two or more kinds.

Examples of the high vapor pressure solvent include α-terpineol, 1,3-butanediol, ethyl carbitol, and propylene glycol diacetate.

The metal paste may contain a solvent having a vapor pressure at 20°C of less than 4 Pa (hereinafter, also referred to as a "low vapor pressure solvent") as a volatile solvent from the viewpoint of suppressing powderization by drying associated with volatilization of the solvent during printing or preparation of the paste. The low vapor pressure solvents may be used alone, or may be used in combination of two or more kinds.

Examples of the low vapor pressure solvent include isobornyl cyclohexanol (MTPH), dimethyl phthalate, and diethylene glycol mono-n-butyl ether.

The metal paste may contain a high vapor pressure solvent and a low vapor pressure solvent from the viewpoint of achieving both printability and suppression of voids or cracks by suppressing volume shrinkage before and after firing the conductive via precursors (for example, between the step of forming the conductive via precursors and the step of firing the conductive via precursors). In this case, the high vapor pressure solvents and the low vapor pressure solvents may each be used alone or in combination of two or more kinds. A content ratio of the high vapor pressure solvent to the low vapor pressure solvent may be 20/80 to 80/20 or 30/70 to 70/30 in terms of mass ratio [high vapor pressure solvent/low vapor pressure solvent]

A content of the volatile solvent in the metal paste may be 8 mass% or more, 7% mass or more, or 6% mass or more, and may be 1 mass% or less, 2 mass% or less, or 3 mass% or less, based on the total mass of the metal paste.

The metal paste may contain a resin component such as an epoxy resin. The metal paste of the present embodiment may have a content of the resin component of 10 mass% or less or 5 mass% or less, or may not contain a resin component.

The metal paste can be prepared by mixing the copper particles described above, solder particles, and arbitrary components (additives, other metal particles, and the like) with the volatile solvent described above. After mixing the respective components, a stirring treatment may be performed. A maximum diameter of a dispersion may be adjusted by a classification operation.

When the metal paste contains the first copper particles and the second particles described above, the second copper particles, the surface treatment agent, and the dispersion medium may be mixed in advance, the dispersion treatment may be performed to prepare a dispersion of the second copper particles, and the first copper particles, the solder particles, and as necessary, other metal particles and arbitrary additives may be further mixed to prepare the dispersion. By adopting such a procedure, the dispersibility of the second copper particles is improved, the mixing property with the first copper particles is improved, and the performance of the metal paste is further improved. The aggregate may be removed by subjecting the dispersion of the second copper particles to a classification operation.

The metal paste may have a viscosity at 25°C of 100 to 600 Pa·s or 150 to 400 Pa·s from the viewpoint of printability. The viscosity of the metal paste is measured using a micro spiral viscometer PCU-02V

(trade name, manufactured by Malcom Co., Ltd.) under conditions of a rotation speed of 10 rpm and a temperature of 25°C.

The compositions of the metal particles and the volatile solvent in the metal particle-containing layer can be appropriately set so that the conditions in the metal paste described above are satisfied. A thickness of the metal particle-containing layer may be 100 µm or less. From the viewpoint of easily securing sufficient filling property into the through-holes or the non-through-holes, the thickness of the metal particle-containing layer may be 30 µm or more, 40 µm or more, or 50 µm or more.

From the viewpoint of suppressing the occurrence of voids in the through-holes or the non-through-holes, the metal particle-containing layer may have waviness (height difference) of 20 µm or less or 10 µm or less on the surface opposite to the support film. By reducing the waviness (height difference), when the metal particle film is pressed to fill the holes of the substrate with the metal particle composition, it becomes easy to simultaneously fill a large number of through-holes or non-through-holes present in the substrate, and it becomes easy to reduce completely unfilled through-holes or non-through-holes and through-holes or non-through-holes in which voids are partially generated. Note that the evaluation of the waviness (height difference) can be measured by a non-contact method using a laser displacement meter or the like.

The metal particle film described above can be produced by applying the metal paste of the present embodiment described above onto a support film to form a metal particle-containing layer having a concentration of metal particles of 94 mass% or more, or applying a metal paste having an increased content (for example, a concentration of the metal particles is increased to an amount of less than 92 mass%) of a volatile solvent, and drying the coating film to form a metal particle-containing layer having a concentration of metal particles of 94 mass% or more.

Examples of a method for applying the metal paste include a method for applying the metal paste using screen printing, transfer printing, offset printing, a jet printing method, a dispenser, a jet dispenser, a needle dispenser, a comma coater, a slit coater, a die coater, a gravure coater, slit coating, relief printing, intaglio printing, gravure printing, stencil printing, soft lithography, bar coating, an applicator, a particle deposition method, a spray coater, a spin coater, a dip coater, or the like.

From the viewpoint of the workability of coating and the uniformity of the coating film thickness, the metal paste can be applied onto the support film by screen printing.

A thickness of the coating film may be 1 µm or more, 2 µm or more, 3 µm or more, 5 µm or more, 10 µm or more, 15 µm or more, or 20 µm or more, and may be 300 µm or less, 250 µm or less, 200 µm or less, 150 µm or less, 120 µm or less, 100 µm or less, 80 µm or less, or 50 µm or less.

The step of drying the coating film to form the metal particle-containing layer can be performed at normal temperature or a temperature of normal temperature to 100°C or lower, and the atmosphere may be in the air or in nitrogen.

In the step a, the metal particle film described above is pressed against the silicon substrate 40 so that the metal particle-containing layer 3p of the metal particle film is in contact with the silicon substrate 40, and the through-hole 30 of the silicon substrate 40 is filled with the metal paste. In this case, for example, as illustrated in FIG. 2(b), the metal particle film and the silicon substrate 40 can be sandwiched and pressurized by a pressure jig A from above and below. The pressure jig A is not particularly limited, may be a commercially available pressure jig, and may be manufactured using a metal member having a flat portion. For example, the pressure jig having two or more metal members can press the metal particle film against the silicon substrate by sandwiching the metal particle film and the silicon substrate between the metal members arranged so that the flat portions face each other. The pressure jig A may have a mechanism that adjusts the pressure applied to the metal particle film and the silicon substrate. As the pressure adjusting means, a spring or the like can be used.

The pressing can be performed, for example, under conditions of a temperature of normal temperature to 50°C or lower, and the atmosphere may be in vacuum, in the air, or in nitrogen. For the purpose of reducing voids, the metal particle film may be pressed against the silicon substrate after being held at a degree of vacuum of 1,000 Pa or less or a degree of vacuum of 200 Pa or less. The pressure of the pressure jig when pressing the metal particle film against the silicon substrate may be a pressure in a range in which the silicon wafer is not cracked, and may be, for example, 0.01 MPa or more, 0.1 MPa or more, or 1 MPa or more.

The metal paste portion 3 may cover at least the surface around the holes of the substrate while filling the inside of the holes, and as illustrated in FIGS. 2(b) and 2(c), the metal paste portion may protrude from an opening (VP₀ in FIG. 2(a)) of the through-hole located on the side opposite to the side where the metal particle film of the substrate is pressed to cover the surface around the holes.

### [Step b]

In the step, the metal paste portion is heated to remove a part of the volatile solvent, and in other words, the metal paste portion is heated so that a part of the volatile solvent (for example, the low vapor pressure solvent described above) remains. Note that, when the metal particle film is used, the metal paste portion can be heated after the support film is peeled off.

For the heating, for example, a hot plate, a warm air dryer, a warm air heating furnace, a nitrogen dryer, an infrared dryer, an infrared heating furnace, a far infrared heating furnace, a microwave heating device, a laser heating device, an electromagnetic heating device, a heater heating device, a steam heating furnace, a hot plate press device, or the like can be used.

The atmosphere to be heated may be the air, may be an oxygen-free atmosphere such as nitrogen and a rare gas, or may be a reducing atmosphere such as hydrogen and formic acid. In the case of the air, when the heating temperature exceeds 100°C, the copper particles are easily oxidized, but when the metal paste portion contains the high vapor pressure solvent described above as a volatile solvent, a part of the volatile solvent can be removed at a temperature of less than 100°C, 95°C or lower, or 90°C or lower. Note that, in a case where the metal paste portion does not contain a high vapor pressure solvent as a volatile solvent, for example, contains only the low vapor pressure solvent described above, when heating is performed at 110°C or higher, 130°C or higher, or 150°C or higher in an oxygen-free atmosphere or a reducing atmosphere, oxidation of the copper particles can be suppressed while removing a part of the volatile solvent.

When the metal paste portion contains a high vapor pressure solvent, the heating temperature may be 70°C or higher and lower than 100°C or 80°C or higher and 95°C or lower from the viewpoint of suppressing oxidation of the copper particles, and the heating time may be 5 to 60 minutes or 10 to 30 minutes from the viewpoint of suppressing oxidation of the copper particles.

In addition, from the viewpoint of suppressing the occurrence of voids or cracks by suppressing volume shrinkage before and after firing the conductive via precursors (for example, between the step of forming the conductive via precursors and the step of firing the conductive via precursors), heating may be performed so that the concentration of the metal particles in the metal paste portion is 96 mass% or more, 97.5 mass% or more, or 98 mass% or more.

### [Step c]

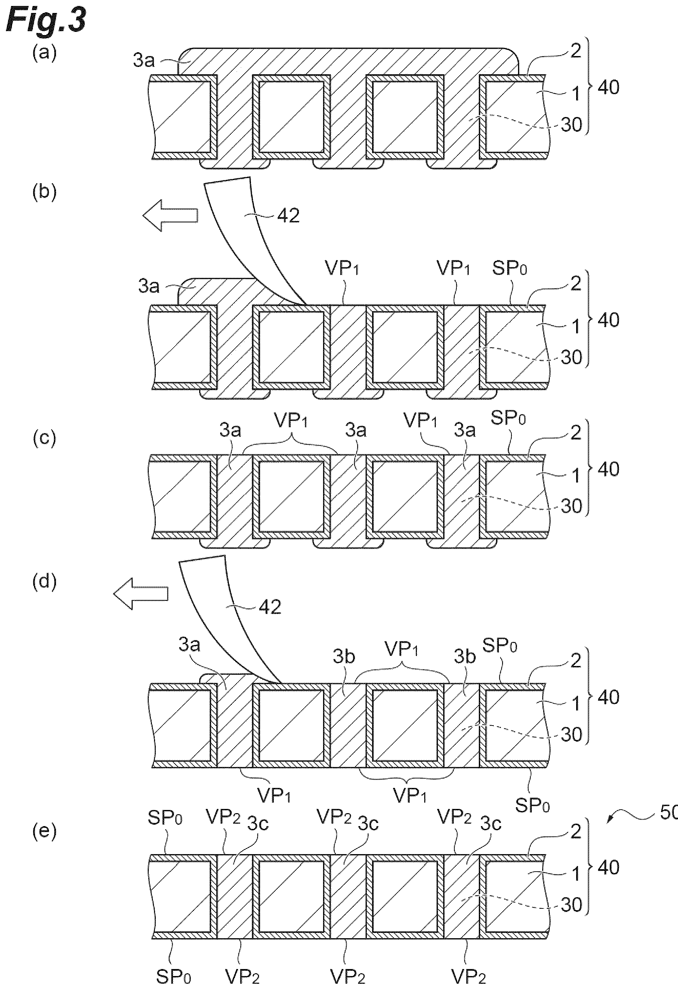

In the step, as illustrated in FIGS. 3(a) to 3(d), the metal paste filling the holes is flattened (or smoothed) while removing the metal paste covering the surface of the substrate from a metal paste portion 3a after heating obtained in the step b. Therefore, a conductive via precursor 3b having a flattened exposed surface VP₁ and containing a remainder of the metal particles and the volatile solvent can be formed inside the hole (through-hole 30) (FIG. 3(d)).

For the removal of the metal paste portion, for example, as illustrated in FIGS. 3(b) and 3(d), a rubber squeegee 42 can be used. Therefore, a part of the metal paste portion (the metal paste covering the surface of the substrate and the metal paste protruding from the hole) can be removed so that a surface SP₀ of the substrate 40 and the exposed surface VP₁ of the conductive via precursor 3b are flush with each other. In addition, another method includes removal with a metal squeegee such as SUS.

A step between the surface SP₀ of the substrate 40 and the exposed surface VP₁ of the conductive via precursor 3b may be 5 µm or less or 3 µm or less in a direction perpendicular to the substrate surface. In addition, an average difference of steps calculated by the following method may fall within the above range.

### (Average Difference of Steps)

An image of a cross section passing through the center of the hole (via) is acquired, the cross-sectional image is binarized to obtain a cross-sectional area Sa surrounded by the inner wall of the hole (via), the exposed surface of the conductive via precursor, and the opening surface of the hole (via), and the cross-sectional area Sa is divided by an interval Wa of the inner wall of the hole to calculate an average difference of steps.

### [Step d]

In the step, the conductive via precursors 3b formed in the step c are fired. Therefore, conductive vias 3c formed of a metal body can be formed. The metal body can include a copper sintered body having a porous structure, solder interspersed in the copper sintered body, and voids.

The firing can be performed by a heat treatment. For the heat treatment, for example, heating means such as a hot plate, a warm air dryer, a warm air heating furnace, a nitrogen dryer, an infrared dryer, an infrared heating furnace, a far infrared heating furnace, a microwave heating device, a laser heating device, an electromagnetic heating device, a heater heating device, or a steam heating furnace can be used.

The atmosphere during firing may be an oxygen-free atmosphere from the viewpoint of suppressing oxidation of the copper sintered body, or may be a reducing atmosphere from the viewpoint of removing the surface oxide of the copper particles in the conductive via precursor. Examples of the oxygen-free atmosphere include introduction of an oxygen-free gas such as nitrogen or a rare gas, or vacuum. Examples of the reducing atmosphere include pure hydrogen gas, a mixed gas of hydrogen and nitrogen represented by forming gas, nitrogen containing formic acid gas, a mixed gas of hydrogen and rare gas, and a rare gas containing formic acid gas. When the conductive via precursors are sintered by heating without pressurization, the conductive via precursors may be in pure hydrogen gas or a mixed gas of hydrogen and nitrogen represented by a forming gas, and are preferably in pure hydrogen gas. Heating is performed in pure hydrogen gas, such that it is possible to lower the sintering temperature of the copper particles. When pure hydrogen gas is used, even when the thickness of the substrate is as large as 600 µm and the diameter of the through-hole 30 is as small as 10 µm, the gas reaches the central portion of the through-hole 30, and it becomes easy to obtain a metal body containing a copper sintered body.

The maximum attained temperature during the heat treatment may be 150°C or higher, and may be 350°C or lower, 300°C or lower, or 260°C or lower, from the viewpoint of reducing heat damage to each member and improving the yield. When the maximum attained temperature is 150°C or higher, sintering tends to proceed sufficiently as long as the maximum attained temperature retention time is 60 minutes or shorter. The maximum attained temperature retention time may be 1 minute or longer, and may be 60 minutes or shorter, 40 minutes or shorter, or 30 minutes or shorter, from the viewpoint of volatilizing all the volatile solvent and improving the yield.

The firing of the conductive via precursors may be performed without pressurization, or may be performed in a state where pressure is applied. In the latter case, in an atmosphere containing pure hydrogen gas, the pressure may be 0.05 MPa or more, 0.1 MPa or more, or 0.3 MPa or more, and may be 20 MPa or less, 15 MPa or less, or 10 MPa or less. In addition, in an atmosphere containing nitrogen gas, the pressure may be 1 MPa or more or 3 MPa or more, and may be 20 MPa or less, 15 MPa or less, or 10 MPa or less.

By setting the pressure to 0.05 MPa or more when pure hydrogen gas is used and 1 MPa or more when nitrogen gas is used, the occurrence of voids in the conductive via formed in the central portion of the through-hole 30 is easily suppressed, and a conductive via having excellent conductivity is easily obtained. In addition, the pressure is set to the above-described lower limit value or more, such that, when the silicon substrate 40 includes the metal coating 2, the bonding strength between the metal coating 2 and the conductive via is easily improved.

In addition, when the pressure applied during firing is within the range described above, a special pressure device is unnecessary, such that the reduction of voids, the bonding strength, and the connection reliability can be further improved without impairing the yield. Examples of a method of applying pressure to the silicon substrate in which the conductive via precursors are formed in the through-holes include a method of placing a weight, a method of applying pressure using a pressure device, and a method of applying pressure using a fixing jig for applying pressure.

In the copper sintered body contained in the metal body, a ratio of the copper element in the elements excluding the light element among the constituent elements may be 95 mass% or more, 97 mass% or more, 98 mass% or more, or 100 mass%. When the ratio of the copper element in the copper sintered body is within the range described above, it is possible to suppress the formation of an intermetallic compound or the precipitation of heterogeneous elements on a metal copper crystal grain boundary, the properties of the metal copper constituting the copper sintered body are easily strengthened, and more excellent connection reliability is easily obtained.

In the step d, since the conductive via precursor has the exposed surface VP₁ which is flat and has a sufficiently small step with respect to the substrate surface, and has a composition in which volume shrinkage hardly occurs by firing, the step between the surface SP₀ of the substrate 40 and an exposed surface VP₂ of the conductive via 3c can be made sufficiently small. Therefore, a substrate with conductive vias having sufficient flatness can be obtained, and a planarization step such as a CMP step can be omitted. Note that, in the present embodiment, a treatment such as chemical polishing, mechanical polishing, chemical mechanical polishing, a fly cutting treatment, and a plasma treatment may be performed as necessary.

The step (or the recess of the conductive via 3c) between the surface SP₀ of the substrate 40 and the exposed surface VP₂ of the conductive via 3c may be 5 µm or less or 3 µm or less in a direction perpendicular to the substrate surface. In addition, an average difference of steps calculated by the following method may fall within the above range.

### (Average Difference of Steps)

An image of a cross section passing through the center of the hole (via) is acquired, the cross-sectional image is binarized to obtain a cross-sectional area Sb surrounded by the inner wall of the hole (via), the exposed surface of the conductive via, and the opening surface of the hole (via), and the cross-sectional area Sb is divided by an interval Wb of the inner wall of the hole to calculate an average difference of steps.

A substrate 50 with conductive vias can be obtained through the steps a to d described above. In the substrate 50 with conductive vias, the exposed surface of the conductive via is flat (smooth), and the step with respect to the surface SP₀ of the substrate 40 is sufficiently small, such that a wiring can be easily formed, and a sufficiently low connection resistance value can be exhibited even after the wiring is formed.

### <Method for Manufacturing Wiring Board with Conductive Vias>

A method for manufacturing a wiring board with conductive vias according to the present embodiment includes a step of forming a wiring on the substrate with conductive vias obtained by the method described above.

The step can include a resist formation step, a plating step, a resist removal step, and an etching step described below.

### <Resist Formation Step>

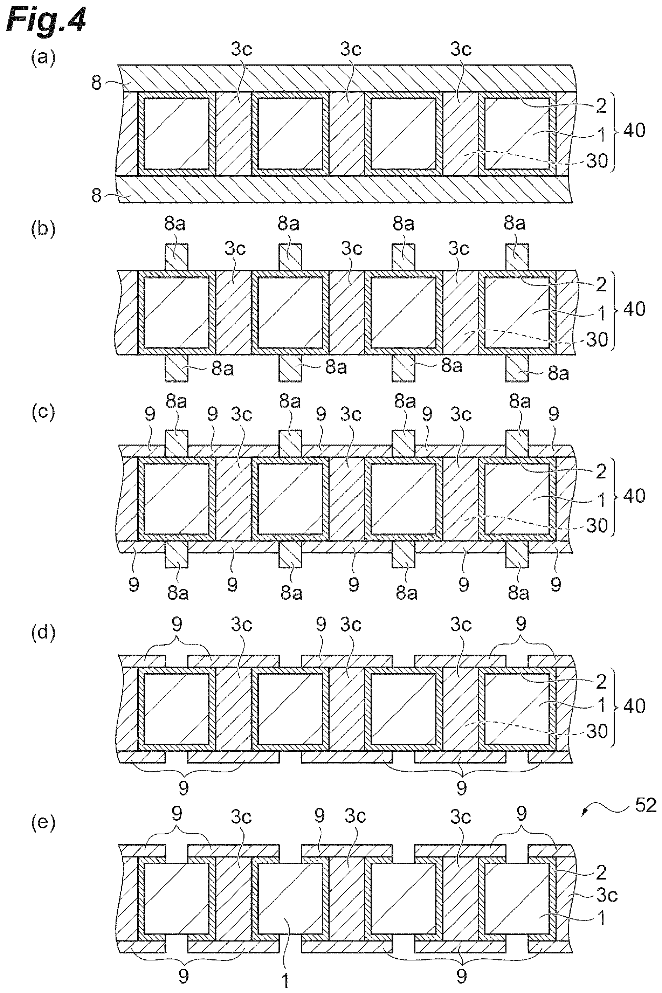

In the resist formation step, for example, as illustrated in FIGS. 4(a) and 4(b), a negative photosensitive dry film 8 for an etching resist is laminated on the main surface of the silicon substrate 40 and the conductive vias 3c, a photomask that transmits light is then superimposed into a wiring shape, exposure is performed with ultraviolet rays, and an unexposed portion is removed with a developer, such that etching resists 8a can be formed.

Examples of a method for forming the etching resists 8a other than the above include a method of silk-screen printing a resist ink and a method of bonding a dry film resist with a laminator.

### <Plating Step>

In the plating step, for example, as illustrated in FIG. 4(c), a wiring 9 can be formed by a method such as electrolytic plating or electroless plating of openings of the etching resists 8a.

### <Resist Removal Step>

In the resist removal step, for example, as illustrated in FIG. 4(d), the etching resists 8a can be removed by a method such as peeling by a wet process using an alkaline aqueous solution or an organic solvent-based chemical solution such as an organic amine-based chemical solution such as TMAH or a ketone-based chemical solution such as acetone, or peeling by a dry process such as plasma or ozone.

### <Etching Step>

In the etching step, the metal coating 2 at a portion not covered with the wiring 9 can be removed by etching. In the present embodiment, a part of the metal coating 2 provided on both main surfaces of the silicon wafer 1 is removed by etching.

Examples of the etching method include a method using a chemical etching solution used for a normal wiring board, such as a solution of cupric chloride and hydrochloric acid, a ferric chloride solution, a solution of sulfuric acid and hydrogen peroxide, or an ammonium persulfate solution.

By the steps described above, a wiring board 52 with conductive vias as illustrated in FIG. 4(e) can be obtained.

Note that, in the method for manufacturing a wiring board with conductive vias according to the present embodiment, the wiring board with conductive vias that forms a wiring may be subjected to a treatment for removing at least a part of the conductor such as a sintered body of a metal paste or the metal coating 2 remaining on the main surface of the silicon substrate 40.

Examples of the means for removing the conductor include chemical polishing, mechanical polishing, chemical mechanical polishing, a fly cutting treatment, and a plasma treatment. The fly cutting treatment means cutting planarization by a surface planer.

### Examples

Hereinafter, the present invention will be described more specifically with reference to Examples and Comparative Examples, but the present invention is not limited to the following Examples.

### [Preparation of Metal Paste]

### (Preparation Examples 1 to 24)

The following raw materials were mixed in the ratios shown in Tables 1 to 3 to prepare metal pastes.

### <First Copper Particles>

### (Wet Copper Powder)

Spherical copper particles W1: 1050Y (trade name, manufactured by MITSUI MINING & SMELTING CO., LTD., average particle diameter (D50): 0.81 µm, spherical shape)
Spherical copper particles W2: 1100Y (trade name, manufactured by MITSUI MINING & SMELTING CO., LTD., average particle diameter (D50): 1.1 µm, spherical shape)
Spherical copper particles W3: 1200Y (trade name, manufactured by MITSUI MINING & SMELTING CO., LTD., average particle diameter (D50): 2.1 µm, spherical shape)
Spherical copper particles W4: 1300Y (trade name, manufactured by MITSUI MINING & SMELTING CO., LTD., average particle diameter (D50): 3.5 µm, spherical shape)
Flat copper particles W1: 1100YP (trade name, manufactured by MITSUI MINING & SMELTING CO., LTD., average particle diameter (D50): 1.4 µm, flat shape)
Flat copper particles W2: 1200YP (trade name, manufactured by MITSUI MINING & SMELTING CO., LTD., average particle diameter (D50): 3.1 µm, flat shape)

### (Atomized Copper Powder)

Spherical copper particles A1: MA-C02K (trade name, manufactured by MITSUI MINING & SMELTING CO., LTD., average particle diameter (D50): 1.8 µm, spherical shape)
Spherical copper particles A2: MA-C025K (trade name, manufactured by MITSUI MINING & SMELTING CO., LTD., average particle diameter (D50): 2.4 µm, spherical shape)
Spherical copper particles A3: MA-C03K (trade name, manufactured by MITSUI MINING & SMELTING CO., LTD., average particle diameter (D50): 3.4 µm, spherical shape)

### <Second Copper Particles>

Spherical copper particles W5: CH0200L1 (trade name, manufactured by MITSUI MINING & SMELTING CO., LTD., average particle diameter (D50): 200 nm, spherical shape)

### <Solder Particles>

Solder particles 1: SnBi58 solder STC-3 (trade name, manufactured by MITSUI MINING & SMELTING CO., LTD., average particle diameter (D50): 4.1 µm, spherical shape)

### <Volatile Solvent>

(High Vapor Pressure Solvent: Vapor Pressure at 20°C Is 4 Pa or More and 30 Pa or Less)
α-Terpineol: manufactured by FUJIFILM Wako Pure Chemical Corporation, vapor pressure at 20°C: 6.5 Pa
1,3-Butanediol: manufactured by SANKYO CHEMICAL CO., LTD., vapor pressure at 20°C: 8 Pa
Ethyl carbitol: manufactured by Showa Chemical Industry Co., Ltd., vapor pressure at 20°C: 13 Pa
Propylene glycol diacetate: manufactured by INOUE PERFUMERY MFG. CO., LTD., vapor pressure at 20°C: 30 Pa
(Low Vapor Pressure Solvent: Vapor Pressure at 20°C Is Less Than 4 Pa)
Isobornyl cyclohexanol: trade name "Terusolve MTPH", manufactured by NIPPON TERPENE CHEMICALS, INC., vapor pressure at 20°C: 0.004 Pa
Dimethyl phthalate: manufactured by Showa Chemical Industry Co., Ltd., vapor pressure at 20°C: 0.2 Pa
Diethylene glycol mono-n-butyl ether: manufactured by Showa Chemical Industry Co., Ltd., vapor pressure at 20°C: 1.3 Pa

For the metal pastes obtained in Preparation Examples 1 to 24, the viscosity, printability, bondability, and volume resistivity were evaluated according to the following methods.

### <Viscosity>

The viscosity of the metal paste was measured using a micro spiral viscometer PCU-02V (trade name, manufactured by Malcom Co., Ltd.). Note that the measurement conditions were a rotation speed of 10 rpm and a temperature of 25°C.

### <Printability>

In <Preparation of Metal Particle Film> described below, when printing was performed on a PET film having a thickness of 100 µm using a screen printer, the number of pinholes formed due to failure of coating on the PET film side was measured. Based on the number of pinholes, printability was evaluated according to the following criteria. Note that the cases evaluated as A to D can be determined to be good.

### (Criteria)

A: The number of pinholes is 0
B: The number of pinholes is 1 or more and less than 3
C: The number of pinholes is 3 or more and less than 5
D: The number of pinholes is 5 or more and less than 10
E: The number of pinholes is 10 or more and less than 20
F: The number of pinholes is 20 or more

In addition, in <Preparation of Metal Particle Film> described below, an 8 inch-φ size coating amount (g) after printing on a PET film having a thickness of 100 µm was measured using a screen printer.

### <Bondability>

A bonding sample for a shear strength test was prepared and die shear strength was measured according to the following method, and bondability was evaluated according to the following criteria. Note that the cases evaluated as A to C can be determined to be good.

### (Preparation of Bonding Sample for Shear Strength Test)

A metal paste was stencil-printed on a copper plate having a size of 25 × 20 × 3 mm in thickness using a stainless steel mask having a square opening of 3 × 3 mm² and having a thickness of 100 µm and a squeegee. After drying at 90°C for 10 minutes using a hot plate, the resulting product was placed in a tube furnace (manufactured by AVC Co., LTD.), and argon gas was caused to flow at a flow rate of 1 L/min to replace the air in the tube furnace with argon gas. Thereafter, the temperature was raised to 225°C for 10 minutes while flowing hydrogen gas at 300 mL/min, and a sintering treatment was performed at 225°C for 60 minutes to sinter the metal paste. Thereafter, the resulting product was cooled by flowing argon gas at a flow rate of 0.3 L/min and taken out into the air at 50°C or lower, thereby obtaining a substrate including a metal body formed on a copper plate as a bonding sample for a shear strength test.

### (Measurement of Die Shear Strength)

For the bonding sample for a shear strength test, the die shear strength was measured using a universal bond tester (4000 series, manufactured by Dage Japan Co., Ltd.) equipped with DS-100 load cell by pressing a metal body or a Cu plate in a horizontal direction under the measurement conditions of a measurement speed of 5 mm/min and a measurement height of 50 µm. An average value of 10 points was calculated and used as an average value of the bonding strength.

### (Criteria)

A: The average value of bonding strength is 50 N or more
B: The average value of bonding strength is 40 N or more and less than 50 N
C: The average value of bonding strength is 20 N or more and less than 40 N
D: The average value of bonding strength is 10 N or more and less than 20 N
E: The average value of bonding strength is less than 10 N

### <Measurement of Volume Resistivity>

The metal paste prepared above was applied onto a glass wafer having a thickness of 1 mm using an automatic film applicator (trade name, manufactured by Allgood Corporation) so that an application thickness was about 150 µm. Note that the coating area was about 5 cm × about 10 cm. Next, the wafer provided with a coating film was dried at 90°C for 10 minutes using a hot plate, and then disposed in a tube furnace (manufactured by AVC Co., LTD.), and argon gas was caused to flow at 1 L/min to replace the air in the tube furnace with argon gas. Thereafter, the temperature was raised to 225°C for 10 minutes while flowing hydrogen gas at 300 mL/min, and a sintering treatment was performed at 225°C for 60 minutes to sinter the metal paste. Thereafter, the resulting product was cooled by flowing argon gas at a flow rate of 0.3 L/min and taken out into the air at 50°C or lower, thereby obtaining a sample in which a metal body was formed on a wafer.

A volume resistivity of the metal body in the sample described above was calculated from the surface resistance value measured with a four-end needle surface resistance measuring instrument (trade name: LORESTA GP, manufactured by Mitsubishi Analytech Co., Ltd.) and the film thickness obtained with a non-contact surface/layer cross-section shape measurement system (VertScan, Ryoka Systems, Inc.).

**[Table 1]**

| | | | | | Preparation Example 1 | Preparation Example 2 | Preparation Example 3 | Preparation Example 4 | Preparation Example 5 | Preparation Example 6 | Preparation Example 7 | Preparation Example 8 | Preparation Example 9 |
|---|---|---|---|---|---|---|---|---|---|---|---|---|---|
| | | | Wet copper powder | Spherical copper particles W1 | 30 | 45 | - | - | - | - | - | - | - |
| | | | | Spherical copper particles W2 | - | - | - | 30 | 45 | - | - | - | - |
| | | | | Spherical copper particles W3 | - | - | - | - | - | - | 30 | 45 | - |
| | | First copper particles | | Spherical copper particles W4 | - | - | - | - | - | - | - | - | - |
| | Copper particles | | | Flat copper particles W1 | - | - | - | - | - | - | - | - | - |
| | | | | Flat copper particles W2 | - | - | - | - | - | - | - | - | - |
| | | | Atomized copper powder | Spherical copper particles A1 | 30 | - | 45 | - | - | - | - | - | - |
| | | | | Spherical copper particles A2 | - | - | - | 30 | - | 45 | - | - | - |
| | | | | Spherical copper particles A3 | - | - | - | - | - | - | 30 | - | 45 |
| Composition | | Second copper particles | Wet copper powder | Spherical copper particles W5 | 30 | 45 | 45 | 30 | 45 | 45 | 30 | 45 | 45 |
| | Solder particles | Solder particles 1 | | | 5 | 5 | 5 | 5 | 5 | 5 | 5 | 5 | 5 |
| | Volatile solvent | High vapor pressure solvent | α-Terpineol (6.5 Pa) | | 2.5 | 2.5 | 2.5 | 2.5 | 2.5 | 2.5 | 2.5 | 2.5 | 2.5 |
| | | | 1,3-Butanediol (8 Pa) | | - | - | - | - | - | - | - | - | - |
| | | | Ethyl carbitol (13 Pa) | | - | - | - | - | - | - | - | - | - |
| | | | Propylene glycol diacetate (30 Pa) | | - | - | - | - | - | - | - | - | - |
| | | Low vapor pressure solvent | Isobornyl cyclohexanol | | 2.5 | 2.5 | 2.5 | 2.5 | 2.5 | 2.5 | 2.5 | 2.5 | 2.5 |
| | | | Dimethyl phthalate | | - | - | - | - | - | - | - | - | - |
| | | | Diethylene glycol mono-n-butyl ether | | - | - | - | - | - | - | - | - | - |
| Property | Viscosity (Pa·s@25°C) | | | | 300 | 368 | 280 | 290 | 353 | 265 | 280 | 335 | 240 |
| | Printability | Determination | | | A | B | B | A | B | A | A | B | A |
| | | Coating amount (g) | | | 4.8 | 5.4 | 3.7 | 3.7 | 5.4 | 3.9 | 3.4 | 5.1 | 3.7 |
| | Bondability | Bonding strength with Cu (N) | | | 65 | 57 | 42 | 63 | 54 | 45 | 65 | 48 | 41 |
| | | Determination | | | A | A | B | A | A | B | A | A | B |
| | Volume resistivity (µΩ·cm) | | | | 4.9 | 4.3 | 7.2 | 5.1 | 4.6 | 5.3 | 7.7 | 4.7 | 8.8 |

**[Table 2]**

| | | | | | Preparation Example 10 | Preparation Example 11 | Preparation Example 12 | Preparation Example 13 | Preparation Example 14 | Preparation Example 15 | Preparation Example 16 | Preparation Example 17 |
|---|---|---|---|---|---|---|---|---|---|---|---|---|
| | | | Wet copper powder | Spherical copper particles W1 | - | - | - | - | 20 | - | 30 | 30 |
| | | | | Spherical copper particles W2 | - | - | - | - | - | - | - | - |
| | | | | Spherical copper particles W3 | - | - | - | - | 20 | - | - | - |
| | | | | Spherical copper particles W4 | - | - | - | - | 20 | - | - | - |
| | Copper particles | First copper particles | | Flat copper particles W1 | 30 | 45 | - | - | - | - | - | - |
| | | | | Flat copper particles W2 | - | - | 30 | 45 | - | - | - | - |
| | | | Atomized copper powder | Spherical copper particles A1 | | - | - | - | - | 20 | 30 | 30 |
| | | | | Spherical copper particles A2 | 30 | - | - | - | - | 20 | - | - |
| | | | | Spherical copper particles A3 | - | - | 30 | - | - | 20 | - | - |
| Composition | | Second copper particles | Wet copper powder | Spherical copper particles W5 | 30 | 45 | 30 | 45 | 30 | 30 | 30 | 30 |
| | Solder particles | Solder particles 1 | | | 5 | 5 | 5 | 5 | 5 | 5 | 5 | 5 |
| | Volatile solvent | High vapor pressure solvent | α-Terpineol (6.5 Pa) | | 2.5 | 2.5 | 2.5 | 2.5 | 2.5 | 2.5 | 5 | 4 |
| | | | 1,3-Butanediol (8 Pa) | | - | - | - | - | - | - | - | - |
| | | | Ethyl carbitol (13 Pa) | | - | - | - | - | - | - | - | - |
| | | | Propylene glycol diacetate (30 Pa) | | - | - | - | - | - | - | - | - |
| | | Low vapor pressure solvent | Isobornyl cyclohexanol | | 2.5 | 2.5 | 2.5 | 2.5 | 2.5 | 2.5 | 0 | 1 |
| | | | Dimethyl phthalate | | - | - | - | - | - | - | - | - |
| | | | Diethylene glycol mono-n-butyl ether | | - | - | - | - | - | - | - | - |
| Property | Viscosity (Pa·s@25°C) | | | | 421 | 520 | 385 | 487 | 452 | 198 | 286 | 295 |
| | Printability | Determination | | | C | D | C | D | C | A | A | A |
| | | Coating amount (g) | | | 6.7 | 9.5 | 8.9 | 10.5 | 7.0 | 5.1 | 4.2 | 4.3 |
| | Bondability | Bonding strength with Cu (N) | | | 58 | 42 | 56 | 41 | 60 | 30 | 65 | 63 |
| | | Determination | | | A | B | A | B | A | C | A | A |
| | Volume resistivity (µΩ·cm) | | | | 5.3 | 9.3 | 5.4 | 9.5 | 10.2 | 12.3 | 4.8 | 5.2 |

**[Table 3]**

| | | | | | Preparation Example 18 | Preparation Example 19 | Preparation Example 20 | Preparation Example 21 | Preparation Example 22 | Preparation Example 23 | Preparation Example 24 |
|---|---|---|---|---|---|---|---|---|---|---|---|
| | | | Wet copper powder | Spherical copper particles W1 | 30 | 30 | 30 | 30 | 30 | 30 | 30 |
| | | | | Spherical copper particles W2 | - | - | - | - | - | - | - |
| | | | | Spherical copper particles W3 | - | - | - | - | - | - | - |
| | | First copper particles | | Spherical copper particles W4 | - | - | - | - | - | - | - |
| | Copper particles | | | Flat copper particles W1 | - | - | - | - | - | - | - |
| | | | | Flat copper particles W2 | - | - | - | - | - | - | - |
| | | | Atomized copper powder | Spherical copper particles A1 | 30 | 30 | 30 | 30 | 30 | 30 | 30 |
| | | | | Spherical copper particles A2 | - | - | - | - | - | - | - |
| | | | | Spherical copper particles A3 | - | - | - | - | - | - | - |
| Composition | | Second copper particles | Wet copper powder | Spherical copper particles W5 | 30 | 30 | 30 | 30 | 30 | 30 | 30 |
| | Solder particles | Solder particles 1 | | | *5* | *5* | *5* | *5* | *5* | *5* | *5* |
| | Volatile solvent | High vapor pressure solvent | α-Terpineol (6.5 Pa) | | 1 | 0 | - | - | - | - | - |
| | | | 1,3-Butanediol (8 Pa) | | - | - | *2.5* | - | - | 2.5 | 2.5 |
| | | | Ethyl carbitol (13 Pa) | | - | - | - | 2.5 | - | - | - |
| | | | Propylene glycol diacetate (30 Pa) | | - | - | - | - | 2.5 | - | - |
| | | Low vapor pressure solvent | Isobornyl cyclohexanol | | 4 | *5* | 2.5 | 2.5 | 2.5 | - | - |
| | | | Dimethyl phthalate | | - | - | - | - | - | 2.5 | - |
| | | | Diethylene glycol mono-n-butyl ether | | - | - | - | - | - | - | 2.5 |
| Property | Viscosity (Pa·s@25°C) | | | | 520 | 670 | 310 | 290 | 274 | 120 | 100 |
| | Printability | Determination | | | D | D | A | A | A | A | A |
| | | Coating amount (g) | | | 4.4 | 4.8 | 5.5 | 4.7 | 4.5 | 4.2 | 4.1 |
| | Bondability | Bonding strength with Cu (N) | | | 27 | 32 | 65 | 65 | 65 | 74 | 84 |
| | | Determination | | | C | C | A | A | A | A | A |
| | Volume resistivity (µΩ·cm) | | | | 5.5 | 6.8 | 4.7 | 4.7 | 4.9 | 4.4 | 3.4 |

### [Preparation of Silicon Substrate with Conductive Vias]

### (Examples 1 to 24)

A silicon substrate with conductive vias was prepared by the following procedure.

### <Preparation of Silicon Substrate>

A silicon substrate provided with a through-hole and having a titanium layer, a nickel layer, and a copper layer formed in this order on both main surfaces and on a wall surface of the through-hole was prepared. Note that the silicon substrate has a diameter of 6 inches and a thickness of 300 µm, the titanium layer, the nickel layer, and the copper layer are sequentially formed by sputtering, and the through-hole has a hole diameter (via diameter) of 30 µm.

### <Preparation of Metal Particle Film>

The metal paste prepared above was printed on a PET film having a thickness of 100 µm with a screen printer in a size of 8 inch-φ (circular shape with a diameter of 20 cm) using a screen printing plate (wiring diameter: 23 µm, number of meshes: 400, mesh size: 41 µm, space ratio: 41 µm) to obtain a metal particle film provided with a metal particle-containing layer.

### <Formation of Conductive Vias>

Using a bonding apparatus VJ-35 (trade name, manufactured by Ayumi Industry Co., Ltd.), the metal particle film was bonded to a silicon substrate from the metal particle-containing layer side, and the laminate was further pressed at room temperature and in the air at a pressure of 3 MPa to fill the through-hole with the metal paste. At this time, the metal paste was protruded on a side of the silicon substrate opposite to a side on which the metal particle film was bonded.

Next, the PET film peeled off from the laminate was dried in the air at 90°C for 10 minutes. Note that, in only Examples 18 and 19, drying was performed at 130°C for 60 minutes in a nitrogen atmosphere (flow rate: 5 L/min). These drying conditions were conditions under which the concentration of the metal particles of the metal paste was changed as follows.
Examples 1 to 15 and 20 to 22: 95 mass% → 97.5 mass%
Example 16: 95 mass% → 99.5 mass%
Example 17: 95 mass% → 99 mass%
Example 18: 95 mass% → 98.4 mass%
Example 19: 95 mass% → 97.6 mass%
Example 23: 95 mass% → 98.2 mass%
Example 24: 95 mass% → 98.5 mass%

For the laminate after drying, as illustrated in FIGS. 3(a) to 3(d), the metal paste on the main surface of the silicon substrate on the side to which the metal particle film was bonded was removed using a rubber squeegee, and subsequently, the metal paste protruding on the side of the silicon substrate opposite to the side to which the metal particle film was bonded was removed using a rubber squeegee.

Next, the silicon substrate in which the conductive via precursors were formed in the through-holes by the process described above was disposed in a tube furnace (manufactured by AVC Co., LTD.), and argon gas was caused to flow at 1 L/min to replace the air in the tube furnace with argon gas. Thereafter, the temperature was raised to 225°C for 10 minutes while flowing hydrogen gas at 300 mL/min, and a sintering treatment was performed at 225°C for 60 minutes to sinter the conductive via precursors. Thereafter, the resulting product was cooled by flowing argon gas at a flow rate of 0.3 L/min and taken out into the air at 50°C or lower, thereby obtaining a silicon substrate with conductive vias.

### <Evaluation of Silicon Substrate with Conductive Vias>

For the silicon substrate with conductive vias obtained above, the presence or absence of cracks and voids in the conductive vias and the recesses after sintering were evaluated according to the following method.

### (Presence or Absence of Cracks in Conductive Vias)

The cross sections of the conductive vias of the silicon substrate with conductive vias were exposed by cross section polishing, 30 conductive vias were observed using a digital microscope (trade name: VHX-6000, manufactured by KEYENCE CORPORATION), and the presence or absence of cracks (10 µm or more in length) was confirmed.

### (Presence or Absence of Voids in Conductive Vias)

The cross sections of the conductive vias of the silicon substrate with conductive vias were exposed by cross section polishing, 30 conductive vias were observed using a digital microscope (trade name: VHX-6000, manufactured by KEYENCE CORPORATION), and the presence or absence of voids (5 µm or more in diameter) was confirmed.

### (Recesses after Sintering)

The cross sections of the conductive vias of the silicon substrate with conductive vias were exposed by cross section polishing, 30 conductive vias were observed using a digital microscope (trade name: VHX-6000, manufactured by KEYENCE CORPORATION), and an average difference of steps was calculated by the following method.

### [Average Difference of Steps]

An image of a cross section passing through the center of the hole was acquired, the cross-sectional image was binarized to obtain a cross-sectional area Sb surrounded by the inner wall of the hole, the exposed surface of the conductive via, and the opening surface of the hole, and the cross-sectional area Sa was divided by an interval Wb of the inner wall of the hole to calculate an average difference of steps (= Sb/Wb).

The average value of the average difference of steps at 30 points was calculated, and the recesses after sintering were evaluated according to the following criteria. Note that the case evaluated as C or higher can be determined to be good.

### (Criteria)

A: The average value of the average difference of steps is less than 1 µm
B: The average value of the average difference of steps is 1 µm or more and less than 3 µm
C: The average value of the average difference of steps is 3 µm or more and less than 5 µm
D: The average value of the average difference of steps is 5 µm or more and less than 10 µm
E: The average value of the average difference of steps is 10 µm or more

### <Evaluation of Wiring Board>

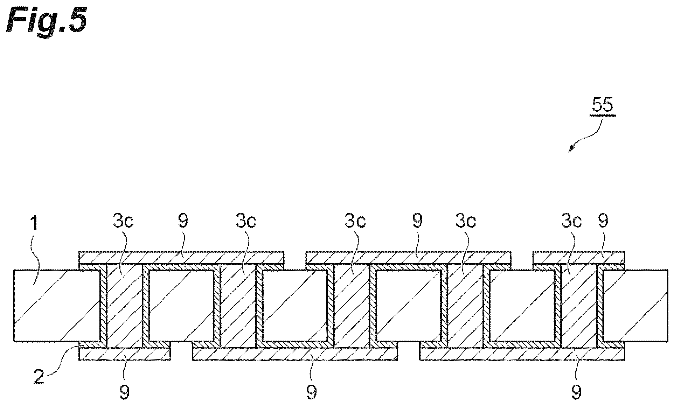

A dry film H-W425 (trade name, manufactured by Resonac Corporation) for an ultraviolet curable etching resist was pressure-bonded to the surface of the silicon substrate with conductive vias obtained above with a laminator. Thereafter, a photomask was aligned to expose the wiring pattern, and resist development was performed. Next, electrolytic plating was performed on the resist opening, and then peeling of the resist and etching of the seed layer were performed to form a wiring having a wiring pattern of 300 µm × 600 µm, thereby obtaining a test piece 55 (wiring board) as illustrated in FIG. 5. In the test piece 55, conductive vias formed in the through-holes were electrically connected by the wiring provided on the substrate surface.

For the test piece obtained above, the initial resistance value, the connection reliability, the presence or absence of cracks in the substrate, and the recesses of the conductive vias after resist peeling were evaluated according to the following methods.

### (Initial Resistance Value)

As an initial resistance value of the test piece 55, a resistance value in which 30 through-holes were connected was measured. Based on the connection resistance value, the initial resistance value was evaluated according to the following criteria. The case where the evaluation is B or higher can be determined as good.

### (Criteria)

A: The resistance value is less than 10 mΩ
B: The resistance value is 10 mΩ or more and less than 30 mΩ
C: The resistance value is 30 mΩ or more and less than 100 mΩ
D: The resistance value is 100 mΩ or more and less than 500 mΩ
E: The resistance value is 500 mΩ or more

### (Connection Reliability)

The test piece 55 was set in a temperature cycle tester (TSA-72SE-W, manufactured by ESPEC CORP.), and a temperature cycle connection reliability test was performed under the conditions of low temperature: -40°C, 15 minutes, room temperature: 2 minutes, high temperature: 125°C, 15 minutes, defrosting cycle: automatic, and number of cycles: 50, 100, 300, and 500 cycles. For the test piece subjected to each number of cycles, the resistance value in which 30 through-holes were connected was measured. Based on the connection resistance value, the connection reliability was evaluated according to the following criteria.

### (Criteria)

A: The resistance change rate is less than 1% with respect to the initial resistance value
B: The resistance change rate is 1% or more and less than 3% with respect to the initial resistance value
C: The resistance change rate is 3% or more and less than 5% with respect to the initial resistance value
D: The resistance change rate is 5% or more and less than 10% with respect to the initial resistance value
E: The resistance change rate is 10% or more and less than 20% with respect to the initial resistance value
F: The resistance change rate is 20% or more with respect to the initial resistance value

### (Cracking of Substrate)

The test piece 55 was visually confirmed, and the presence or absence of cracking of the silicon substrate was confirmed.

### (Recesses after Resist Peeling)

In the preparation of the test piece 55, after the resist was peeled off, the cross sections of the conductive vias were exposed by cross section polishing, 30 conductive vias were observed using a digital microscope (trade name: VHX-6000, manufactured by KEYENCE CORPORATION), and an average value of the average difference of steps was calculated in the same manner as in the evaluation of the recesses after sintering. Then, the recesses after resist peeling were evaluated according to the following criteria. Note that the case evaluated as C or higher can be determined to be good.

### (Criteria)

A: The average value of the average difference of steps is less than 1 µm
B: The average value of the average difference of steps is 1 µm or more and less than 3 µm
C: The average value of the average difference of steps is 3 µm or more and less than 5 µm
D: The average value of the average difference of steps is 5 µm or more and less than 10 µm
E: The average value of the average difference of steps is 10 µm or more

### [Observation and Consideration of Conductive Vias]

### (Observation 1)

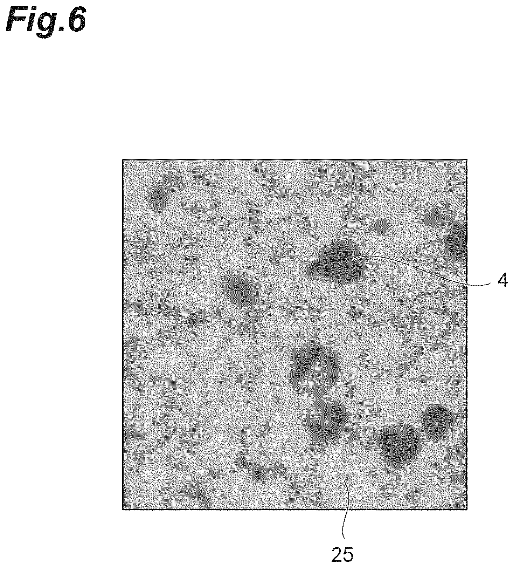

For the silicon substrate with conductive vias prepared in Example 1, a cross section of the conductive via was exposed by cross section polishing, and a cross-sectional image was captured using a digital microscope (trade name: VHX-6000, manufactured by KEYENCE CORPORATION) (see FIG. 6). As illustrated in FIG. 6, the conductive via includes a copper sintered body, solder 25, and a gap 4, and the gap exists in the copper sintered body, the inside of the solder, and the outer peripheral portion of the solder (between the solder and the copper sintered body).

### (Observation 2)

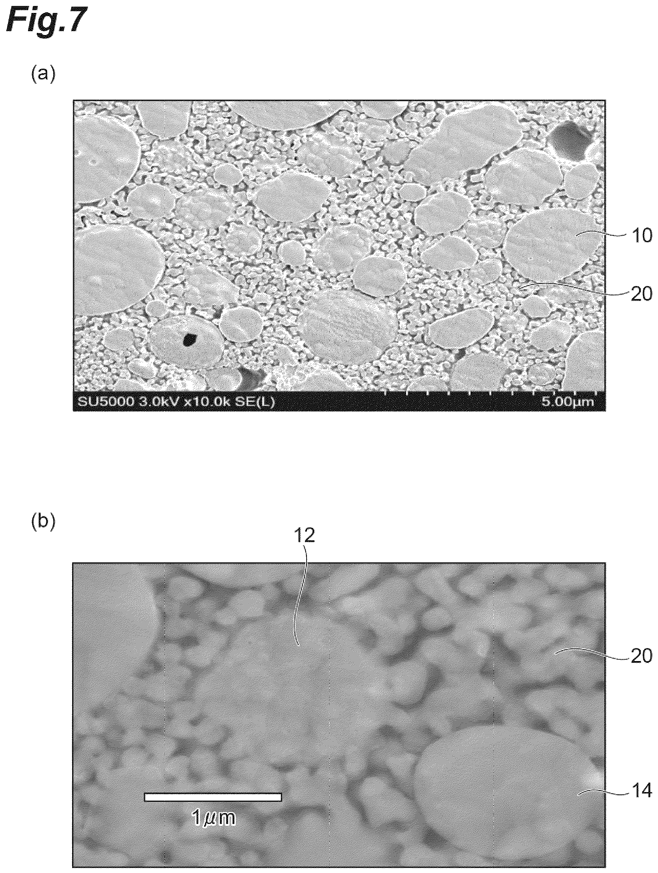

Using a focused ion beam machining observation device (trade name: MI4050, manufactured by Hitachi High-Technologies Corporation), the cross section of the central portion of the conductive via of the silicon substrate with conductive vias was exposed by the focused ion beam, and the cross section was observed. For the observation, a cross-sectional image (about 10 µm square) of the copper sintered body was captured using a scanning electron microscope (trade name: S-3700N, manufactured by Hitachi High-Technologies Corporation) at a magnification of 10,000 times (see FIG. 7). As illustrated in FIG. 7(a), the copper sintered body has a structure in which first copper particles 10 are distributed in second copper particles 20. In addition, as confirmed in the enlarged view of the cross-sectional image illustrated in FIG. 7(b), in the first copper particles, a wet copper powder 12 has a property of being more easily bonded to the second copper particles than an atomized copper powder 14, but the connection reliability can be further improved by using the wet copper powder and the atomized copper powder in combination. Such an effect is considered to be due to the fact that the wet copper powder 12 that is easily bonded to the second copper particles and the atomized copper powder 14 having a wide particle diameter distribution coexist, and the wet copper powder 12 is bonded to the second copper particles while bonding between the atomized copper powders 14, such that the formation of a rigid sintered body due to the closest packed structure, the suppression of the occurrence of voids or cracks due to suppression of shrinkage during sintering, and the suppression of recesses can be highly achieved.

**[Table 4]**

| | | | Example 1 | Example 2 | Example 3 | Example 4 | Example 5 | Example 6 | Example 7 | Example 8 | Example 9 |
|---|---|---|---|---|---|---|---|---|---|---|---|
| Metal paste | | | Preparation Example 1 | Preparation Example 2 | Preparation Example 3 | Preparation Example 4 | Preparation Example 5 | Preparation Example 6 | Preparation Example 7 | Preparation Example 8 | Preparation Example 9 |
| Substrate | | Material | Silicon | Silicon | Silicon | Silicon | Silicon | Silicon | Silicon | Silicon | Silicon |
| | | Type of hole | Through | Through | Through | Through | Through | Through | Through | Through | Through |
| | | Via diameter (µm) | 30 | 30 | 30 | 30 | 30 | 30 | 30 | 30 | 30 |
| | | Via depth (µm) | 300 | 300 | 300 | 300 | 300 | 300 | 300 | 300 | 300 |
| Step a | | Filling method | Vacuum press | Vacuum press | Vacuum press | Vacuum press | Vacuum press | Vacuum press | Vacuum press | Vacuum press | Vacuum press |
| Step b | | Temperature (°C) | 90 | 90 | 90 | 90 | 90 | 90 | 90 | 90 | 90 |
| | | Atmosphere | In air | In air | In air | In air | In air | In air | In air | In air | In air |
| Step c | | Removal method | Squeegee | Squeegee | Squeegee | Squeegee | Squeegee | Squeegee | Squeegee | Squeegee | Squeegee |
| Step d | | Temperature (°C) | 220 | 220 | 220 | 220 | 220 | 220 | 220 | 220 | 220 |
| | | Atmosphere | 100% H₂ | 100% H₂ | 100% H₂ | 100% H₂ | 100% H₂ | 100% H₂ | 100% H₂ | 100% H₂ | 100% H₂ |
| Conductive vias | Cracks | | Absent | Absent | Absent | Absent | Absent | Absent | Absent | Absent | Absent |
| | Voids | | Absent | Absent | Absent | Absent | Absent | Absent | Absent | Absent | Absent |
| | Recesses after sintering | (µm) | 0.6 | 1.5 | 1.5 | 0.6 | 1.5 | 2.5 | 0.7 | 1.9 | 2.8 |
| | | Determination | A | B | B | A | B | B | A | B | B |
| | Recesses after resist peeling | (µm) | 0.8 | 1.8 | 1.9 | 0.8 | 2.3 | 2.8 | 0.9 | 2.9 | 3.6 |
| | | Determination | A | B | B | A | B | B | A | B | C |
| Wiring board | Initial resistance value | | A | A | A | A | A | A | A | A | A |
| | After reliability test | 50 times | A | A | A | A | A | A | A | A | A |
| | | 100 times | A | A | A | A | A | A | A | A | A |
| | | 300 times | A | B | B | A | B | B | A | B | B |
| | | 500 times | A | B | B | A | B | B | A | B | B |
| | Cracking of substrate | | Absent | Absent | Absent | Absent | Absent | Absent | Absent | Absent | Absent |

**[Table 5]**

| | | | Example 10 | Example 11 | Example 12 | Example 13 | Example 14 | Example 15 | Example 16 | Example 17 |
|---|---|---|---|---|---|---|---|---|---|---|
| Metal paste | | | Preparation Example 10 | Preparation Example 11 | Preparation Example 12 | Preparation Example 13 | Preparation Example 14 | Preparation Example 15 | Preparation Example 16 | Preparation Example 17 |
| Substrate | | Material | Silicon | Silicon | Silicon | Silicon | Silicon | Silicon | Silicon | Silicon |
| | | Type of hole | Through | Through | Through | Through | Through | Through | Through | Through |
| | | Via diameter (µm) | 30 | 30 | 30 | 30 | 30 | 30 | 30 | 30 |
| | | Via depth (µm) | 300 | 300 | 300 | 300 | 300 | 300 | 300 | 300 |
| Step a | | Filling method | Vacuum press | Vacuum press | Vacuum press | Vacuum press | Vacuum press | Vacuum press | Vacuum press | Vacuum press |
| Step b | | Temperature (°C) | 90 | 90 | 90 | 90 | 90 | 90 | 90 | 90 |
| | | Atmosphere | In air | In air | In air | In air | In air | In air | In air | In air |
| Step c | | Removal method | Squeegee | Squeegee | Squeegee | Squeegee | Squeegee | Squeegee | Squeegee | Squeegee |
| Step d | | Temperature (°C) | 220 | 220 | 220 | 220 | 220 | 220 | 220 | 220 |
| | | Atmosphere | 100% H₂ | 100% H₂ | 100% H₂ | 100% H₂ | 100% H₂ | 100% H₂ | 100% H₂ | 100% H₂ |
| Conductive vias | Cracks | | Absent | Absent | Absent | Absent | Absent | Absent | Absent | Absent |
| | Voids | | Absent | Absent | Absent | Absent | Absent | Absent | Absent | Absent |
| | Recesses after sintering | (µm) | 2.7 | 3.4 | 2.9 | 3.5 | 2.7 | 2.5 | 2.9 | 1.9 |
| | | Determination | B | C | C | C | B | B | B | B |
| | Recesses after resist peeling | (µm) | 3.4 | 3.9 | 3.9 | 4.5 | 3.9 | 3.2 | 4.3 | 3.2 |
| | | Determination | C | C | C | C | C | C | C | C |
| Wiring board | Initial resistance value | | A | A | A | A | A | A | A | A |
| | After reliability test | 50 times | A | B | A | B | A | A | A | A |
| | | 100 times | A | B | A | B | B | B | A | A |
| | | 300 times | B | B | B | B | B | B | A | A |
| | | 500 times | C | C | C | C | B | B | B | A |
| | Cracking of substrate | | Absent | Absent | Absent | Absent | Absent | Absent | Absent | Absent |

**[Table 6]**

| | | | Example 18 | Example 19 | Example 20 | Example 21 | Example 22 | Example 23 | Example 24 |
|---|---|---|---|---|---|---|---|---|---|
| Metal paste | | | Preparation Example 18 | Preparation Example 19 | Preparation Example 20 | Preparation Example 21 | Preparation Example 22 | Preparation Example 23 | Preparation Example 24 |
| Substrate | | Material | Silicon | Silicon | Silicon | Silicon | Silicon | Silicon | Silicon |
| | | Type of hole | Through | Through | Through | Through | Through | Through | Through |
| | | Via diameter (µm) | 30 | 30 | 30 | 30 | 30 | 30 | 30 |
| | | Via depth (µm) | 300 | 300 | 300 | 300 | 300 | 300 | 300 |
| Step a | | Filling method | Vacuum press | Vacuum press | Vacuum press | Vacuum press | Vacuum press | Vacuum press | Vacuum press |
| Step b | | Temperature (°C) | 130 | 130 | 90 | 90 | 90 | 90 | 90 |
| | | Atmosphere | 100% N₂ | 100% N₂ | In air | In air | In air | In air | In air |
| Step c | | Removal method | Squeegee | Squeegee | Squeegee | Squeegee | Squeegee | Squeegee | Squeegee |
| Step d | | Temperature (°C) | 220 | 220 | 220 | 220 | 220 | 220 | 220 |
| | | Atmosphere | 100% H₂ | 100% H₂ | 100% H₂ | 100% H₂ | 100% H₂ | 100% H₂ | 100% H₂ |
| Conductive vias | Cracks | | Absent | Absent | Absent | Absent | Absent | Absent | Absent |
| | Voids | | Absent | Absent | Absent | Absent | Absent | Absent | Absent |
| | Recesses after sintering | (µm) | 2 | 1.5 | 0.6 | 0.6 | 0.6 | 0.4 | 0.3 |
| | | Determination | B | B | A | A | A | A | A |
| | Recesses after resist peeling | (µm) | 2.8 | 2.9 | 0.8 | 0.8 | 0.8 | 0.6 | 0.4 |
| | | Determination | B | B | A | A | A | A | A |
| Wiring board | Initial resistance value | | A | A | A | A | A | A | A |
| | After reliability test | 50 times | A | A | A | A | A | A | A |
| | | 100 times | A | A | A | A | A | A | A |
| | | 300 times | A | A | A | A | A | A | A |
| | | 500 times | A | A | A | A | A | A | A |
| | Cracking of substrate | | Absent | Absent | Absent | Absent | Absent | Absent | Absent |

As shown in Tables 4 to 6, it can be seen that according to the method of Examples, the step between the exposed surface of the conductive via and the substrate surface after sintering can be made sufficiently small, and a substrate with conductive vias having sufficient flatness can be easily obtained. In addition, according to the method of Examples, it can be seen that a wiring board with conductive vias having a wiring that is preferably connected by the conductive vias can be easily obtained.

### Reference Signs List

- 1: Silicon wafer
- 2: Metal coating
- 3: Metal paste portion
- 3b: Conductive via precursor
- 3c: Conductive via
- 3p: Metal particle-containing layer
- 7: Support film
- 8a: Etching resist
- 9: Wiring
- 30: Through-hole
- 31: Non-through-hole
- 40, 41: Silicon substrate
- 42: Rubber squeegee
- 50: Substrate with conductive vias
- 52: Wiring board with conductive vias
- 55: Test piece
- A: Pressure jig

## Claims

1. A method for manufacturing a substrate with conductive vias, the method comprising:
a step a of preparing a substrate provided with holes, and providing a metal paste portion containing metal particles and a volatile solvent so as to fill the inside of the holes and cover at least a surface of the substrate around the holes;
a step b of heating the metal paste portion to remove a part of the volatile solvent;
a step c of removing a part of the metal paste portion after heating so as to expose the surface, and forming conductive via precursors having a flattened exposed surface and containing a remainder of the metal particles and the volatile solvent inside the holes; and
a step d of firing the conductive via precursors.

2. The method according to claim 1, wherein a concentration of the metal particles in the metal paste portion provided in the step a is 94 mass% or more, and
in the step b, the metal paste portion is heated so that the concentration of the metal particles is 97.5 mass% or more.

3. The method according to claim 1, wherein the volatile solvent contains a high vapor pressure solvent having a vapor pressure at 20°C of 4 Pa or more and 30 Pa or less, and
a heating temperature in the step b is lower than 100°C.

4. The method according to claim 1, wherein in the step a, a metal particle film including a support film and a metal particle-containing layer provided on the support film and containing the metal particles and the volatile solvent is prepared, and the metal paste portion is provided by pressing the metal particle-containing layer of the metal particle film against the substrate.

5. A method for manufacturing a wiring board with conductive vias, the method comprising a step of forming a wiring on a substrate with conductive vias obtained by the method according to any one of claims 1 to 4.
